(19) Europäisches Patentamt

European Patent Office

Office européen des brevets

(11) **EP 1 220 448 B1**

(12) **EUROPEAN PATENT SPECIFICATION**

(45) Date of publication and mention
of the grant of the patent:
**03.03.2004 Bulletin 2004/10**

(51) Int Cl.⁷: **H03K 4/502**

(21) Application number: **01130836.8**

(22) Date of filing: **27.12.2001**

(54) **Ramp voltage generator circuit with improved dynamic**

Rampensignalerzeuger mit verbesserter Dynamik

Générateur de signaux à pente avec dynamique amélioré

(84) Designated Contracting States:
**DE FR GB IT**

(30) Priority: **29.12.2000 EP 00830869**

(43) Date of publication of application:
**03.07.2002 Bulletin 2002/27**

(73) Proprietor: **STMicroelectronics S.r.l.**
**20041 Agrate Brianza (Milano) (IT)**

(72) Inventors:
• **Zerilli, Tommaso**
**95030 Tremestieri Etneo (CT) (IT)**

• **Gaibotti, Maurizio**
**20031 Cesano Maderno (MI) (IT)**

(74) Representative: **Ferreccio, Rinaldo**
**c/o Botti & Ferrari S.r.l.,**
**Via Locatelli, 5**
**20124 Milano (IT)**

(56) References cited:
**SU-A- 1 615 864**      **US-A- 6 040 996**

## Description

The present invention refers to a generator circuit for voltage ramps having an improved dynamic operation and corresponding voltage generation method.

Particularly the invention refers to a generator circuit for voltage ramps having an improved dynamic operation of the type comprising a differential stage with positive feedback, having an output connected to the control terminal of a first output transistor connected to a capacitive load to be biased with voltage ramps.

The invention also refers to a method for generating voltage ramps in biasing circuits of capacitive loads for memory devices, of the. type in which said load receives a double ramp voltage signal with a first predetermined slope and a second slope lower than the preceding one.

The invention is particularly, but not exclusively, referred to a generator circuit for voltage ramps used to program cells in a non-volatile memory of the EEPROM type and the following description is made to this application field with the only aim of simplifying its explanation.

The use of such a generator circuit also in the field of EPROM and FLASH-EEPROM memories is immediately known to the experts in the field.

### Prior Art

As it is well known, in the last generation EEPROM memories, either of the "general purpose" or of the "embedded" types, two fundamental specifications, that are a reduction of the writing time and a greater reliability of the whole memory device, are required.

In particular, in the memories that use the method of Fowler-Nordheim for writing the cells, these two needs are actually in contrast with each other. In fact, in order to guarantee a certain reliability degree, in terms of time of keeping the information and of maximum number of writing cycles allowed, the cell is programmed by a ramp voltage pulse with a slope such to guarantee a control of the highest peak of the Fowler-Nordheim current that goes trough the tunnel oxide layer of the cell.

It is in fact known that such a current peak, that is the main responsible of the decay of a memory cell, is directly co-related to the ramp slope of the programming voltage.

For this reason, in this field ramp generators are very important and they have to be projected in order to guarantee a good control of the voltage slope apart from the output load.

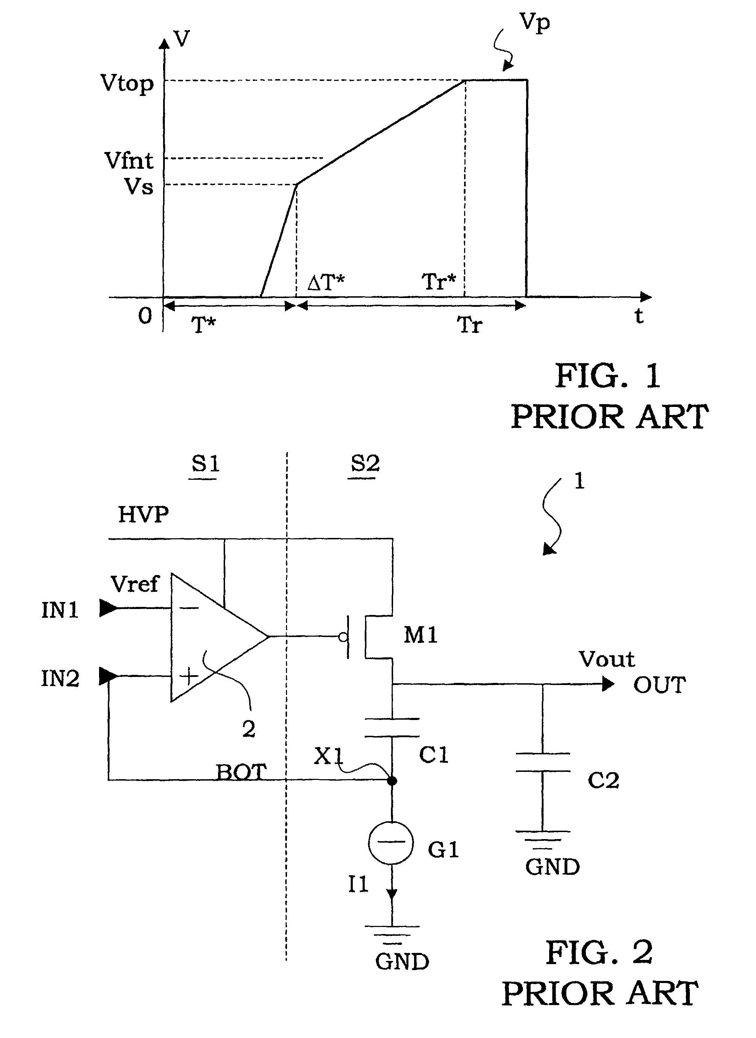

Indeed, in order to solve the problem of reducing the programming time, a voltage pulse called double ramp voltage pulse, is used as it is schematically shown in figure 1.

In particular, the programming pulse shown in said figure 1 shows a first line, starting from an initial time T*-AT* with a duration of AT*, showing a ramp pattern with a first high slope and a second line, starting from a time T* for a duration equal to a Tr*, having a ramp pattern with a second slope lower than the first slope. It is also provided a third line at a null slope for a total duration equal to Tr.

The voltage value Vp of such a programming pulse goes from an initial value conventionally equal to 0 to a first value equal to Vs during the first portion of the ramp in order to reach and maintain a top value equal to Vtop during the second portion of the ramp, while the third portion is constant with the top value Vtop.

The use of this double ramp pulse drastically reduces the duration of a first programming step. In fact during such a first phase the Fowler-Nordheim tunneling has not shown out yet or is still of negligible entity and the pulse voltage Vp is maintained below a triggering voltage Vfnt of such a tunneling. The same programming pulse appears then with a second slope efficient for a second programming phase that still uses the Fowler-Nordheim tunneling; in this case, the pulse voltage Vp reaches greater values than the triggering voltage Vfnt.

As far as the EEPROM memory is concerned, typical values are considered which are equal to:

- Vs = 6 ÷ 8V

- Vtop = 11 ÷ 15 V

- Tr = 0.5 ÷ 1ms

- Slopes allowed to the second part of the ramp < 20 V/ms

In order to obtain significant time reductions, the first part of the programming voltage ramp Vp must indeed have slopes higher than 50 V/ms.

A ramp generator projected in order to provide such a double ramp pulse must therefore control suitable currents, keeping into consideration that the loads to be driven in the global programmings of whole selected memory matrixes result in being in the order of nanofarads.

A further complication in projecting such ramp generators derives from the necessity of reducing the top values operated inside said generators by means of the memory devices in order to face up to the scaling effects deriving from the use of a more and more reduced integration geometry.

This need imposes the use of lower and lower boosted voltage levels and also the project of ramp generators that use the top voltage available inside the memory device as much as possible.

A typical ramp generator of the known type, used to generate a double ramp programming pulse for memory cells of the EEPROM type, is schematically shown in figure 2.

The ramp generator 1 comprises an operational amplifier 2 supplied by a first supply voltage reference HVP, in particular a voltage HVP generated by means of a booster incorporated in the memory device that is not illustrated since it is not conventional. Said first voltage reference HVP coincides to the top voltage available inside the memory device.

The operational amplifier 2 also shows a first inverter input terminal IN1, on which a first reference voltage Vref and a second non-inverter input terminal IN2, receiving a second internal voltage BOT, are applied.

Such a reference Vref voltage is generated for example by means of a Bandgap circuit (that is also not illustrated since it is conventional).

An output terminal of the operational amplifier 2 is connected to a control terminal of a MOS transistor M1 of the P type, that is in turn inserted between said first voltage reference HVP and an output terminal OUT of the ramp generator 1.

The output terminal OUT of the ramp generator 1 is further connected to a second voltage reference, particularly to a GND mass through the series of a first capacitor C1 and a current 11 generator G1. Between the output terminal OUT and the GND mass there is also a second load capacitor C2.

The interconnection node X1 between the first capacitor C1 and the generator G1 is feedback connected to the second non-inverter input terminal IN2 of the operational amplifier 2.

The second capacitor C2 substantially corresponds to the load seen(?) by the ramp generator 1, the value of which particularly depends on the number of bytes selected in the memory matrix to be programmed.

The current generator G1 is indeed obtained by a reference value already available inside the memory device and can be varied by means of suitable mirror current relations in order to obtain the first and the second required slopes. In fact, the output voltage Vout of the ramp generator 1 shows a ramp pattern having a slope equal to:

$$\text{Slope} = I1/C1$$

It should be noted that the ramp generator 1 has a first amplification stage S1, essentially comprising the operational amplifier 2 and a second output stage S2 comprising the transistor M1, the capacitors C1 and C2 and the generator G1.

Particularly, the first amplification stage S1 biases, by means of a virtual short circuit , the current generator G 1 so that:

$$dVout/dt = I1/C1 - dV1/dt = I1/C1 = K$$

Vout being the output voltage of the ramp generator 1:

V1 being the potential present at the terminal X1;

K being the required slope.

Indeed, the output stage S2 operates a voltage/current conversion. In particular, the use of the MOS transistor M1 of the P type in the output stage S2 allows a suitable gm transconductance value to be obtain, as well as a regulation of the loop gain of the set operational amplifier 2/ transistor M1/ capacitor C1, thanks to the amplification of the first stage S1, so that the maximum value of the voltage ramp produced by the generator G1 and by the first capacitor C1 is exactly equal to the top voltage value of the memory device.

Although it is advantageous under many points of view, this first solution shows many drawbacks, particularly the one of stabilization in frequency.

In fact, the sizing of single components of the ramp generator 1 must be taken keeping into consideration of an lout current, to be operated by the output terminal OUT, given by:

$$Iout = C2 \, (dVout/dt)$$

Such sizing must also provide a suitable phase margin in order to guarantee the ramp generator 1 stability in case of variability during its manufacturing process, as well as depending on the operation temperature range of the same, on the supply voltage range and on the applied load variations.

All this causes a great manufacturing difficulty and the sizing of the ramp generator 1 according to the prior art.

In fact, because of the extended variability of the parameters, even a simulated phase margin of 35 degrees could not guarantee the necessary safety in terms of generator stability as a whole. It is suitable to note that such a margin phase can be only obtained with a great waste of area (so called compensation with dominant pole) or with factors PSRR unsuitable for the type of application (so called zero-pole compensation).

A second known solution provides the use of an output stage S2 of the voltage follower type, that is a stage that uses an output MOS transistor of the N type.

In such a way an intrinsically steady ramp generator 1 is obtained, and also an output Voltage Vout of a maximum value invalidated by a threshold voltage value of a transistor of the N type, that is a value lower than the one predetermined or desired for a correct memory cells programming.

The technical problem at the basis of the present invention is the one of providing a double ramp voltage generator, particularly for programming memory cells, having structural and functional features such to allow to overcome the limitations that have up to now afflicted the generators according to the prior art.

## Summary of the invention

The resolutive idea at the basis of the present invention is the one of using a first output stage showing a mixed structure with a pair of transistors, PMOS and NMOS, each activated at a corresponding portion of the voltage ramp.

On the basis of such a resolutive idea, the technical problem is solved by a ramp generator of the type previously indicated and defined by the characterizing part of claim 1.

The problem is also solved by a method of the type previously indicated and defined by the characterizing part of claim 12.

The characteristics and the advantages of the generator and of the method according to the invention will be apparent from the following description, and from an embodiment thereof given by way of non-limitative example with reference to the accompanying drawings.

## Brief description of the drawings

In such drawings:

Figure 1 schematically shows a double ramp pulse for programming memory cells;

Figure 2 schematically shows a ramp generator performed according to the prior art;

Figure 3 schematically shows a ramp generator performed according to the invention;

Figures 4A and 4B schematically show a modified embodiment of a particular ramp generator of figure 3;

Figures 5 to 9 schematically show the pattern of suitable signals inside the ramp generator of figure 3.

## Detailed description

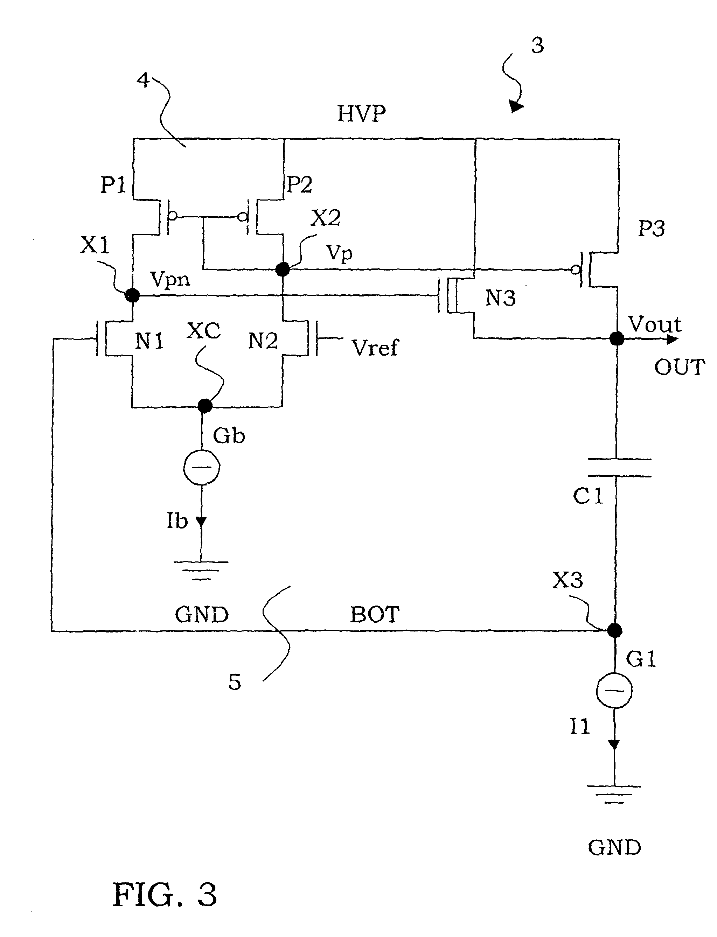

With reference to such figures, and particularly to figure 3, a ramp generator according to the invention is globally and schematically shown at 3.

The ramp generator 3 according to the invention has been realized according to the principle for which the major contribute, in terms of output voltage, is required at low voltage levels, that is during a first programming phase that uses a voltage ramp at a high slope (fast slope).

During this first programming phase, a voltage follower stage is then enough to provide the ramp voltage pattern at a high slope, as required by the specifications. Furthermore, such a voltage follower stage allows to obtain also the necessary current contribute if it is suitably sized.

During a second programming phase that uses a ramp with a lower slope, the voltage output from the ramp generator 3 is at least three times lower and can be generated through a circuit showing a PMOS type output stage, and with a reduced value of the current capacity. It is thus obtained an increase on the phase margin higher than the one that would be obtained in the case of an output stage formed in order to guarantee a suitable voltage value to be outputted during the fast slope. Particularly, an output stage of the PMOS type with a reduced value of the product between the transconductance (gm) and the loop gain (A) will be taken hereafter into consideration.

Advantageously, according to the invention the ramp generator 3 shows a mixed structure comprising a follower voltage PMOS output stage, in which a low output gain of a single-ended differential structure is used to drive the PMOS output stage.

The ramp generator 3 comprises thus a differential structure 4, that is inserted between a first high voltage reference and a second voltage reference, particularly a ground GND.

The differential structure 4 comprises a first N1 and a second N2 input MOS transistors of the N type, which are inserted between the first high voltage Reference HVP and a second voltage reference, particularly a ground GND. More particularly such transistors N1 and N2 have a conduction terminal in common in a node coupled to the ground GND by means of a first generator Gb of a control current Ib.

The second NMOS transistor N2 has a control terminal that represents the input of the operational amplifier 4 and that receives a reference voltage Vref, while the first NMOS transistor N1 has a control terminal connected to an internal circuit node X3.

The differential structure 4 further comprises a biasing stage comprising a first P1 and a second P2 MOS transistors of the P type. Such first P1 and second P2 PMOS transistors form a current mirror with a ratio equal to K and are inserted between the fist high voltage reference HVP and the input transistor pair N 1 and N2.

An interconnection node X1 between the transistor P1 and the transistor N1 is a first output of the differential structure 4. An interconnection node X2 between the transistors P2 and N2 represents a second output of the differential structure 4.

Advantageously according to the invention, the ramp generator 3 further comprises a first output NMOS transistor N3 inserted between the first high voltage reference HVP and an output terminal OUT of the ramp generator 3. Such a transistor N3 has a control terminal connected to the first output X1 of the differential structure 4. A second output transistor P3, this time of the P type, is in turn inserted between the first high voltage reference HVP and the output terminal OUT, and has a control terminal connected to the second output X2.

The first output transistor N3 is essentially connected in parallel to the second output transistor P3, but it is driven by a different output of the differential structure 4. In a preferred embodiment the transistor N3 is of the natural type.

Finally, the output terminal OUT is connected towards ground GND by means of a capacitor C1, that is in turn coupled to the ground GND by means of a second generator G1 of a current I1.

An interconnection node X3 between the capacitor C1 and the second generator G1 is connected to a control terminal of the transistor N1.

At the circuit nodes X1, X2, X3 there are the corresponding voltage signals Vpn, Vp and BOT.

The set of the capacitor C1, of the first NMOS transistor N1 and of the first NMOS output transistor N3 forms a feedback loop 5 for the output terminal OUT of the ramp generator 3.

In such a way at the output terminal OUT is obtained an output voltage Vout signal having a double ramp pattern that is analogous to the one shown in figure 1 with reference to the prior art, comprising a first portion of fast slope and a second portion of slow slope.

Hereafter it will be described the operation of the ramp generator 3 according to the invention.

The current value that flows through the second output PMOS transistor P3 is co-related to the control current Ib of the second generator G1.

When the current value required by the output terminal OUT, and thus by the load to be driven, exceeds the half (Ib/2) of the control current Ib, the differential structure 4 forces the first internal voltage signal Vpn at the node X1 to increase of a suitable quantity equal to the value necessary to the first output NMOS transistor N3 to provide the exceeding current.

The main advantage of the ramp generator 3 according to the invention is that the sizing of the first output transistor N3 is made on the basis of the maximum foreseen load without caring about possible instability effects occurring inside the feedback loop 5 of the ramp generator 3.

The sizing of the second output PMOS transistor P3 is made depending on the maximum current required during the second part of the slow slope. In fact, as soon as the first internal voltage signal Vpn reaches the maximum allowed value, that is the value of the first high voltage reference HVP, the first output NMOS transistor N3 turns off and the last portion of the voltage ramp Vout generated at the output terminal OUT of the ramp generator 3 is generated by means of only the second output PMOS transistor P3.

In particular, such last portion shifts the output voltage Vout value from HVP - Vth(N3) to HVP, Vth(N3) being the threshold voltage value of the first output NMOS transistor N3.

Also in this case, the output ramp regulation does not show particular problems, since it is possible to act simply on the mirror ratio K until the loads to handle are in the order of hundreds of pF. In such a case, in fact, by imposing a mirror ratio K equal to 1, in order to obtain a required slope of 10V/ms, it happens that the current to be handled is equal to 1uA (100pF*10V/ms).

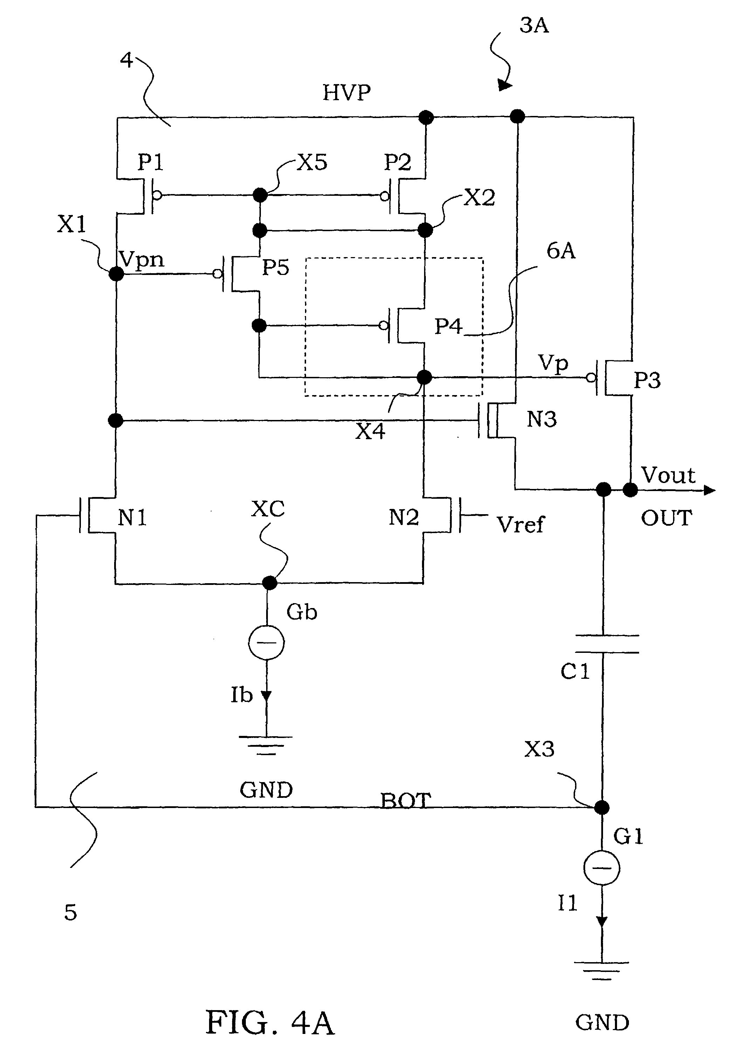

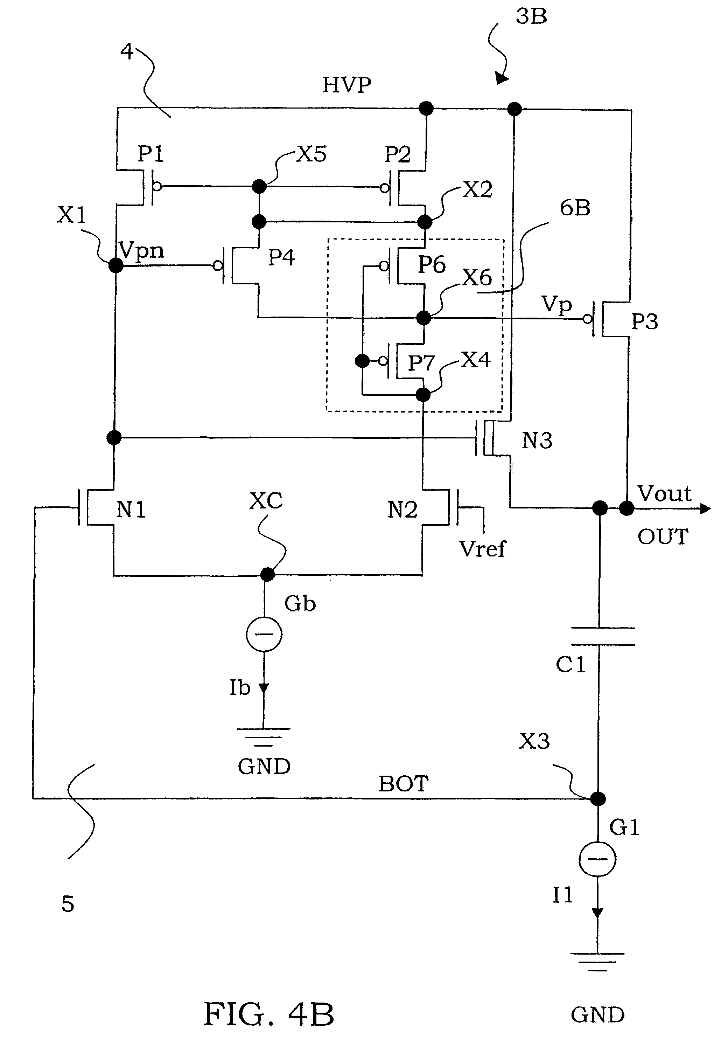

When the load exceeds such a value, reaching for example the nanoFarad, a value of the mirror ratio K higher than 10 should be imposed, or a higher value for the control Ib current should be used. In such a case, it is preferred to use a first and a second variations of the ramp generator 3 according to the invention that comprises an increasing overdrive network, as schematically shown in figures 4A and 4B,

In particular, figure 4A shows a ramp generator 3A comprising an overdrive increasing network 6A corresponding to an entire threshold voltage value of a PMOS transistor, while figure 4B shows a ramp generator 3B, comprising an overdrive increasing network 6B corresponding to a fraction of such a threshold voltage.

As it has been seen describing the solution of figure 3, the ramp generator 3A comprises a first biasing PMOS transistor P1 and a second biasing PMOS transistor P2 which are current mirror configured and connected to the first N1 and the second N2 input NMOS transistors respectively, as well as to the first generator Gb of the control current Ib. The ramp generator 3A further comprises the second generator G1 and the capacitor C1 inserted in the feedback loop 5 between the output terminal OUT and the control terminal of the first NMOS transistor N1.

Advantageously according to said first modified embodiment, the differential structure 4 further comprises an overdrive increasing network 6A which is inserted between the output terminal X2 of the differential structure 4 and a terminal X4 corresponding to the drain terminal of the NMOS transistor N2, that is in turn connected to the control terminal of the output PMOS transistor P3.

More particularly, the overdrive increasing network 6A essentially comprises a diode connected PMOS transistor P4 which is inserted between the node X2 and the node X4.

The ramp generator 3A also comprises a further PMOS transistor P5 which is inserted between a node X5, corresponding to the control terminals shared by the biasing transistors P1 and P2 and the node X4, and having a control terminal connected to the node X1 whereat the first internal voltage signal Vpn is. The node X5 is in turn connected to the node X2.

This structure uses once more two outputs of the differential structure 4, the outputs of which correspond to the nodes X1 and X4.

It is suitable to note that the overdrive increasing network 6A uses a simple mechanism for automatically increasing the overdrive of the first output PMOS transistor P3, by essentially using the dynamic evolution of the first output X1 of the differential structure 4 whereat the first voltage internal signal Vpn is.

The overdrive increase obtained by means of the overdrive increasing network 6A is thus equal to an entire threshold value of a MOS transistor of the P type.

In figure 4B a second modified embodiment of the ramp generator 3 is shown and generally and schematically indicated with 3B.

Also in the case of this second modified embodiment, the ramp generator 3B comprises an overdrive increasing network 6B which is inserted between the node X2 and the node X4 of the differential structure 4 of the ramp generator 3B and connected to the PMOS transistor P3.

More particularly, this overdrive increasing network 6B comprises a first overdrive PMOS transistor P6 inserted between the node X2 and a further node X6 and having the control terminal connected to the control terminal of a second overdrive PMOS transistor P7 that is diode connected and in turn inserted between the node X6 and the node X4 corresponding to the drain terminal of the second NMOS transistor N2.

The node X6 is in turn connected to the control terminal of the second output PMOS transistor P3.

In this modified embodiment, the PMOS transistor P5 is inserted between the node X5, connected in turn to the node X2, and the node X6, connected in turn to the control terminal of the second output transistor P3.

It should be noted that the overdrive increasing network uses anyway a mechanism for increasing the output PMOS transistor P3 overdrive by utilizing the dynamic evolution of the first output X1 of the differential structure 4 whereat the first voltage internal signal Vpn is, and by splitting such an increase over said first P6 and second P7 overdrive transistors.

The figures from 5 to 9 schematically show the results of a simulation performed on the inventive ramp generator 3 and on its modified embodiments.

In particular, the two extreme loading conditions have been kept into consideration, that are a first programming case (A) of a single Byte, with an approximate load of 20pF in relation to the programming output voltage Vout, and a second case (B) for global programming the whole selected memory cell matrix, in case of a matrix of 512 Kbit this load being of about 800 pF in relation to the programming output voltage Vout.

Further, the differential structure 4 is biased by means of a current of 1uA, while the ramp generator uses a current of 500nA for carrying out the first part of fast slope and of about 170nA for carrying out the second part of slow slope.

The value of the reference voltage Vref (generated for example by means of a Bandgap circuit) is constant and equal to 1.33V.

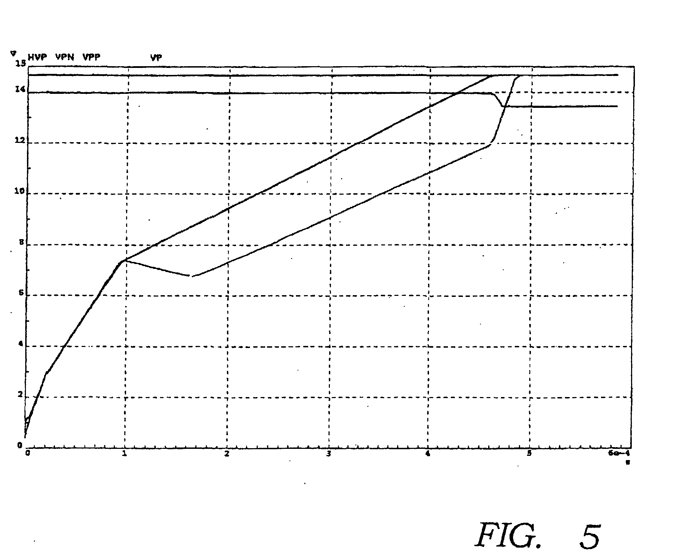

Figure 5 schematically shows the pattern of the output voltage Vout signal that is obtained in the first case (A) by programming a single Byte, and the pattern of the voltage internal signals Vpn and Vp.

It is first considered that the first high voltage reference HVP is at its standard value (in the example it has been used value of 15V) and that the first Vpn and the second voltage internal signals Vp are at the beginning in a certain defined state, that is 0 and HVP.

In particular it is possible to consider a suitable start-up circuitry that provides for the resetting of the initial conditions.

The first voltage internal signal Vpn at the first output X1 of the differential structure 4 leads the output voltage Vout signal throughout the voltage follower stage comprising the first output NMOS transistor N3 during the whole period of the fast slope.

In such a way the node X2, whereat the second voltage internal signal Vp is, reaches the necessary value for correctly biasing the second output PMOS transistor P3.

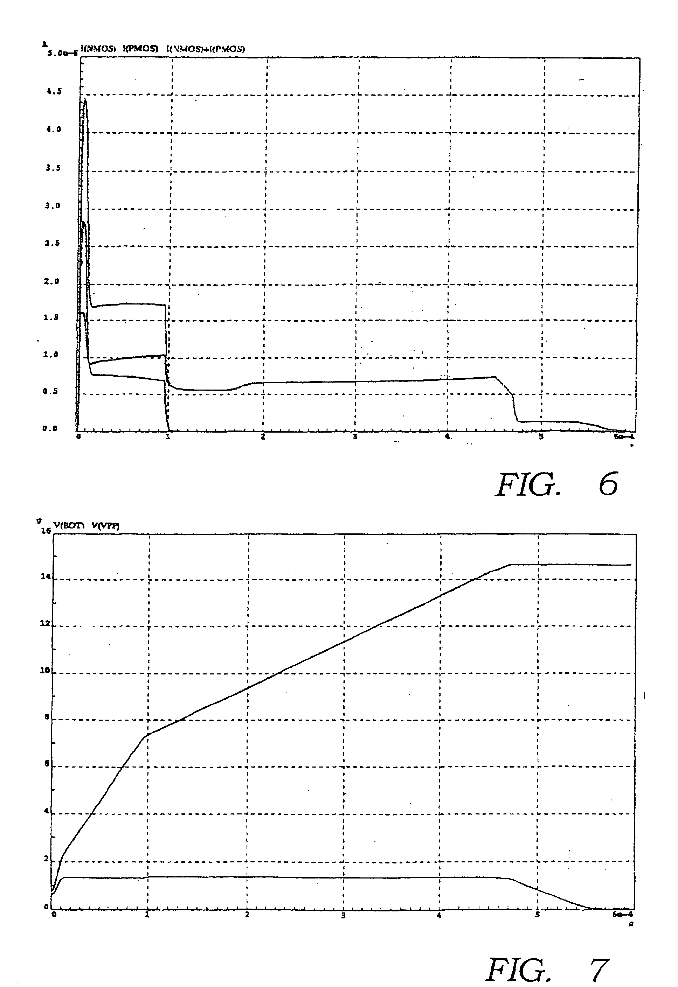

As it is shown in figure 6, the voltage follower output stage, comprising the second PMOS transistor P3, injects a constant current that is certainly of a insufficient value into the output terminal OUT during the fast slope, since the current required by the load is of about 1.7uA (500nA + 20pF*60V/ms) > 1 uA, that is the maximum current that the second output PMOS transistor P3 can supply.

During the slow slope the current required by the output terminal OUT is indeed equal to about 400nA (= 20pF*20V/ms): the contribute of the voltage follower output stage is therefore not necessary anymore and the first node X1, whereat the first voltage internal signal Vpn is, goes below the level of the output voltage Vout signal, thereby turning completely off the voltage follower output stage.

Actually the ramp generator 3 according to the invention is performed in such a way that the first voltage internal signal Vpn is not completely discharged but follows at a certain distanced rate (extra current contribute of 200nA = 10pF*20V/ms since the first voltage internal signal Vpn is charged with a concentrated capacitor of 10pF due to stability reasons) the output voltage signal Vout.

As soon as the output voltage signal Vout at the output terminal OUT reaches the first high voltage reference HVP, the differential structure 4 increases, through the second voltage internal signal Vp, the second output PMOS transistor P3 overdrive, since the drain-source voltage Vds of such a transistor approximates to 0, but the current generator G1 continues to require current (of about 170nA).

The current generator G1 turns completely off when the internal circuit node X3 whereat the third internal voltage signal BOT is, turns out to be discharged (as it is schematically shown in figure 7).

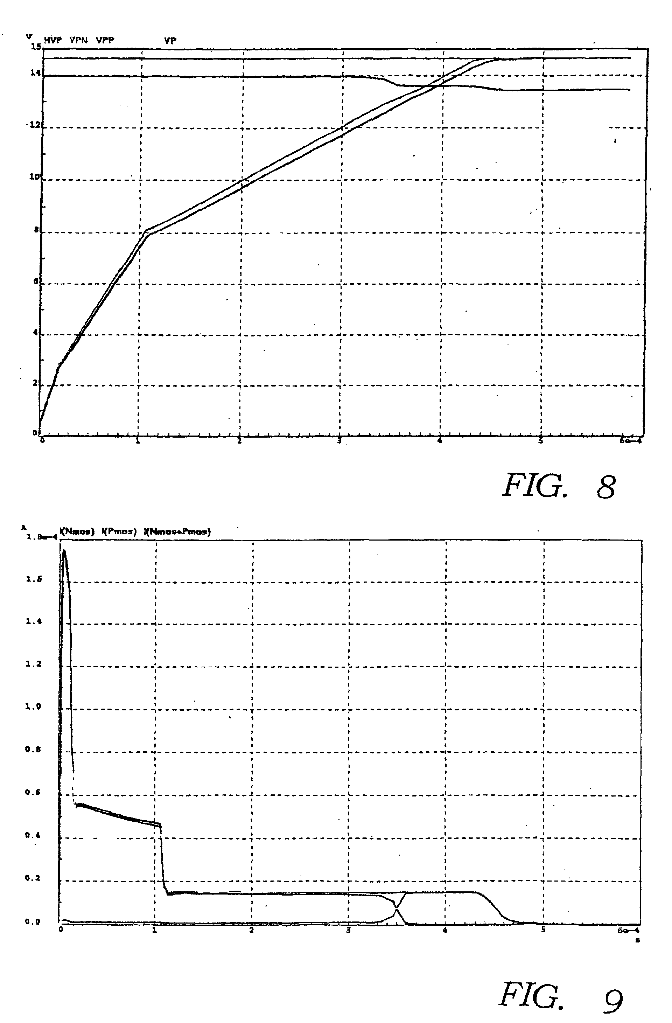

In the second case (B) of global programming, given the same conditions of the previous case, it is possible to note in figures 8 and 9 how the voltage follower output stage, comprising the second output PMOS transistor P3, remains active also during the slow slope.

## Claims

1. A generator circuit (3) for voltage ramps having an improved dynamic operation of the type comprising a differential stage (4) with positive feedback inserted between a first (HVP) and a second voltage reference (GND) and having a first output (X2) connected to a control terminal of a first output transistor (P3) that is in turn connected at an output terminal (OUT) of said ramp generator circuit (3) to a capacitive charge (C1) to be biased with voltage ramps, comprising :

   - a regulation loop (5) inserted between said output terminal (OUT) and said differential stage (4), said regulation loop (5) in turn including said capacitative charge (C1) connected to a current generator (G1); and

   - a second output transistor (N3) parallel connected to said first output transistor (P3) and having the control terminal connected to a second output (X1) of said differential stage (4).

2. A generator circuit (3) for voltage ramps according to claim 1, **characterized in that** the second output transistor (N3) has conduction terminals connected to said first voltage reference (HVP) and to said output terminal (OUT) respectively.

3. A generator circuit (3) for voltage ramps according to claim 1, **characterized in that** said first output transistor (P3) is of the P channel MOS type.

4. A generator circuit (3) for voltage ramps according to claim 1, **characterized in that** said second output transistor (N3) is of the N channel natural MOS type.

5. A generator circuit (3) for voltage ramps according to claim 1, **characterized in that** it further comprises an overdrive increasing network (6A) inserted between said first output (X2) and said control terminal of said first output transistor (P3).

6. A generator circuit (3) for voltage ramps according to claim 5, **characterized in that** said overdrive increasing network (6A) comprises at least a transistor (P4) which is diode connected and inserted between said first output (X2) and said control terminal of said first output transistor (P3).

7. A generator circuit (3) for voltage ramps according to claim 5, **characterized in that** it further comprises a transistor (P5) which is inserted between said first output (X2) and said control terminal of said first output transistor (P3) and having a control terminal connected to said second output (X1) of said differential stage (4).

8. A generator circuit (3) for voltage ramps according to claim 1, **characterized in that** it comprises an overdrive increasing network (6B) which is inserted between said first output (X2) and an internal node (X4) of said differential stage (4) and connected to said control terminal of said first output transistor (P3).

9. A generator circuit (3) for voltage ramps according to claim 8, **characterized in that** said overdrive increasing network (6B) comprises at least a first and a second PMOS transistors (P6, P7) inserted in series between said first output (X2) and said internal node (X4) of said differential stage (4) and connected with each other at an internal circuit node (X6) that is in turn connected to said control terminal of said first output transistor (P3).

10. A generator circuit (3) for voltage ramps according to claim 9, **characterized in that** said first PMOS transistor (P6) is inserted between said first output (X2) and said internal circuit node (X6) and is provided with a control terminal connected to a control terminal of said second PMOS transistor (P7) that is diode shaped and in turn inserted between said internal circuit node (X6) and said internal node (X4) of said differential stage (4).

11. A generator circuit (3) for voltage ramps according to claim 8, **characterized in that** it further comprises a transistor (P5) which is inserted between said first output (X2) and said control terminal of said first output transistor (P3) and having a control terminal connected to said second output (X1) of said differential stage (4).

12. A method for generating a double ramp voltage signal for a capacitive load, said double ramp voltage signal having said first portion whose slope is higher than a second portion, **characterized in that** said generation of said double ramp voltage comprises a first phase carried out by means a NMOS voltage follower stage connected to said capacitive load , and a second phase carried out by means of a PMOS output stage, said phases being alternatively activated depending on the voltage level required by the load, using a generator circuit as defined in any preceding claim.

13. A method according to claim 12, **characterized in that** said second phase is carried out by means of a PMOS output stage with a reduced value of the product between transconductance (gm) and loop gain (A).

14. A method according to claim 12, **characterized in**

**that** said first and second phases are carried out by means of:

- said first output transistor (P) which is driven by a second output (X1) of said differential stage (4); and
- said regulation loop (5) for activating the first or the second output transistors (P3, N3) depending on the required voltage level required by said load.

**Patentansprüche**

1.  Generatorschaltung (3) für Spannungsrampen mit einer verbesserten dynamischen Arbeitsweise des Typs, der eine Differenzstufe (4) mit einer positiven Rückkopplung aufweist, die zwischen einer ersten (HVP) und einer zweiten Referenzspannung (GND) eingesetzt ist und einen ersten Ausgang (X2) aufweist, der an einen Steueranschluss eines ersten Ausgangstransistors (P3) angeschlossen ist, der wiederum an einem Ausgangsanschluss (OUT) der Rampengeneratorschaltung (3) an eine kapazitive Last (C1) angeschlossen ist, um mit Spannungsrampen vorgespannt zu werden, aufweisend:

    - eine Regelschleife (5), die zwischen dem Ausgangsanschluss (OUT) und der Differenzstufe (4) angeschlossen ist, wobei die Regelschleife (5) ihrerseits die kapazitive Last (C1) umfasst, die an einen Stromgenerator (G1) angeschlossen ist; und

    - einen zweiten Ausgangstransistor (N3), der dem ersten Transistor (P3) parallel geschaltet ist und der einen Steueranschluss aufweist, der an einen zweiten Ausgang (X1) der Differenzstufe (4) angeschlossen ist.

2.  Generatorschaltung (3) für Spannungsrampen nach Anspruch 1, **dadurch gekennzeichnet, dass** der zweite Ausgangstransistor (N3) Durchleitanschlüsse aufweist, die an die erste Referenzspannung (HVP) bzw. an den Ausgangsanschluss (OUT) angeschlossen sind.

3.  Generatorschaltung (3) für Spannungsrampen nach Anspruch 1, **dadurch gekennzeichnet, dass** der erste Ausgangstransistor (P3) vom p-Kanal-MOS-Typ ist.

4.  Generatorschaltung (3) für Spannungsrampen nach Anspruch 1, **dadurch gekennzeichnet, dass** der zweite Ausgangstransistor (N3) vom natürlichen n-Kanal-MOS-Typ ist.

5.  Generatorschaltung (3) für Spannungsrampen nach Anspruch 1, **dadurch gekennzeichnet, dass** sie ferner ein Übersteuerungserhöhungsnetzwerk (6A) aufweist, das zwischen dem ersten Ausgang (X2) und dem Steueranschluss des ersten Ausgangstransistors (P3) eingesetzt ist.

6.  Generatorschaltung (3) für Spannungsrampen nach Anspruch 5, **dadurch gekennzeichnet, dass** das Übersteuerungserhöhungsnetzwerk (6A) mindestens einen Transistor (P4) aufweist, der als Diode geschaltet ist und der zwischen dem ersten Ausgang (X2) und dem Steueranschluss des ersten Ausgangstransistors (P3) eingesetzt ist.

7.  Generatorschaltung (3) für Spannungsrampen nach Anspruch 5, **dadurch gekennzeichnet, dass** sie ferner einen Transistor (P5) aufweist, der zwischen dem ersten Ausgang (X2) und dem Steueranschluss des ersten Ausgangstransistors (P3) eingesetzt ist und der einen Steueranschluss aufweist, der an den zweiten Ausgang (X1) der Differenzstufe (4) angeschlossen ist.

8.  Generatorschaltung (3) für Spannungsrampen nach Anspruch 1, **dadurch gekennzeichnet, dass** sie ferner ein Übersteuerungserhöhungsnetzwerk (6B) aufweist, das zwischen dem ersten Ausgang (X2) und einem internen Knoten (X4) der Differenzstufe (4) eingesetzt ist und an den Steueranschluss des ersten Ausgangstransistors (P3) angeschlossen ist.

9.  Generatorschaltung (3) für Spannungsrampen nach Anspruch 8, **dadurch gekennzeichnet, dass** das Übersteuerungserhöhungsnetzwerk (6B) mindestens einen ersten und einen zweiten PMOS-Transistor (P6, P7) aufweist, die in Serienschaltung zwischen dem ersten Ausgang (X2) und dem internen Knoten (X4) der Differenzstufe (4) eingesetzt sind und die miteinander an einen internen Schaltungsknoten (X6) angeschlossen sind, der wiederum an den Steueranschluss des ersten Ausgangstransistors (P3) angeschlossen ist.

10. Generatorschaltung (3) für Spannungsrampen nach Anspruch 9, **dadurch gekennzeichnet, dass** der erste PMOS-Transistor (P6) zwischen dem ersten Ausgang (X2) und dem internen Schaltungsknoten (X6) eingesetzt ist und mit einem Steueranschluss versehen ist, der an einen Steueranschluss des zweiten PMOS-Transistors (P7) angeschlossen ist, der als Diode geschaltet ist und der wiederum zwischen dem internen Schaltungsknoten (X6) und dem internen Knoten (X4) der Differenzstufe (4) eingesetzt ist.

11. Generatorschaltung (3) für Spannungsrampen nach Anspruch 8, **dadurch gekennzeichnet, dass** sie ferner einen Transistor (T5) aufweist, der zwischen dem ersten Ausgang (X2) und dem Steueranschluss des ersten Ausgangstransistors (P3) eingesetzt ist und der einen Steueranschluss aufweist, der an den zweiten Ausgang (X1) der Differenzstufe (4) angeschlossen ist.

12. Verfahren zum Erzeugen eines Doppelrampenspannungssignals für eine kapazitive Last, wobei das Doppelrampenspannungssignal einen ersten Bereich aufweist, dessen Steigung höher ist als die eines zweiten Bereichs, **dadurch gekennzeichnet, dass** die Erzeugung der Doppelrampenspannung eine erste Phase, die mittels einer NMOS-Spannungsfolgerstufe durchgeführt wird, die an die kapazitive Last angeschlossen ist, und eine zweite Phase umfasst, die mittels einer PMOS-Ausgangsstufe durchgeführt wird, wobei die Phasen in Abhängigkeit des von der Last benötigten Spannungsniveaus alternativ aktiviert werden, wobei eine Generatorschaltung gemäß einem der vorstehenden Ansprüche verwendet wird.

13. Verfahren nach Anspruch 12, **dadurch gekennzeichnet, dass** die zweite Phase mittels einer PMOS-Ausgangsstufe mit einem reduzierten Wert für das Produkt aus Steilheit (gm) und Schleifenverstärkung (A) durchgeführt wird.

14. Verfahren nach Anspruch 12, **dadurch gekennzeichnet, dass** die erste und die zweite Phase durchgeführt werden durch:

-   den ersten Ausgangstransistor (P), der durch einen zweiten Ausgang (X1) der Differenzstufe (4) angesteuert wird; und

-   die Regelschleife (5) zum Aktivieren des ersten oder des zweiten Ausgangstransistors (P3, N3) in Abhängigkeit von dem von der Last benötigten Spannungsniveau.

**Revendications**

1.  Un circuit générateur (3) pour rampes de tension présentant un fonctionnement dynamique perfectionné du type comprenant un étage différentiel (4) avec rétroaction positive inséré entre une première (HVP) et une seconde référence de tension (GND) et possédant une première sortie (X2) reliée à une borne de commande d'un premier transistor de sortie (P3) qui est à son tour relié à une borne de sortie (OUT) dudit circuit générateur de rampe (3) à une charge capacitive (C1) à polariser par des rampes de tension, comprenant :

-   une boucle de régulation (5) insérée entre ladite borne de sortie (OUT) et ledit étage différentiel (4), ladite boucle de régulation (5) comprenant à son tour ladite charge capacitive (C1) reliée à un générateur de courant (G1) ; et

-   un second transistor de sortie (N3) reliée en parallèle audit premier transistor de sortie (P3) et ayant la borne de commande reliée à une seconde sortie (X1) dudit étage différentiel (4).

2.  Un circuit générateur (3) pour rampes de tension selon la revendication 1, **caractérisé en ce que** le second transistor de sortie (N3) a des bornes de conduction reliées à ladite première référence de tension (HVP) et à ladite borne de sortie (OUT) respectivement.

3.  Un circuit générateur (3) pour rampes de tension selon la revendication 1, **caractérisé en ce que** le premier transistor de sortie (P3) est du type MOS à canal P.

4.  Un circuit générateur (3) pour rampes de tension selon la revendication 1, **caractérisé en ce que** le second transistor de sortie (N3) est du type MOS naturel à canal N.

5.  Un circuit générateur (3) pour rampes de tension selon la revendication 1, **caractérisé en ce qu'**il comprend en outre un réseau d'augmentation de surattaque (6A) inséré entre ladite première sortie (X2) et ladite borne de commande dudit premier transistor de sortie (P3).

6.  Un circuit générateur (3) pour rampes de tension selon la revendication 5, **caractérisé en ce que** ledit réseau d'augmentation de surattaque (6A) comprend au moins un transistor (P4) qui est relié par diode et inséré entre ladite première sortie (X2) et ladite borne de commande dudit premier transistor de sortie (P3).

7.  Un circuit générateur (3) pour rampes de tension selon la revendication 5, **caractérisé en ce qu'**il comprend en outre un transistor (P5) qui est inséré entre ladite première sortie (X2) et ladite borne de commande dudit premier transistor de sortie (P3) et possédant une borne de commande reliée à ladite seconde sortie (X1) dudit étage différentiel (4).

8.  Un circuit générateur (3) pour rampes de tension selon la revendication 1, **caractérisé en ce qu'**il comprend un réseau d'augmentation de surattaque (6B) inséré entre ladite première sortie (X2) et un noeud interne (X4) dudit étage différentiel (4) et relié à ladite borne de commande dudit premier transistor de sortie (P3).

9.  Un circuit générateur (3) pour rampes de tension selon la revendication 8, **caractérisé en ce que** ledit réseau d'augmentation de surattaque (6B) comprend au moins un premier et un second transistors PMOS (P6, P7) insérés en série entre ladite première sortie (X2) et ledit noeud interne (X4) dudit étage différentiel (4) et reliés l'un à l'autre à un noeud interne de circuit (X6) qui est à son tour relié à ladite borne de commande dudit premier transistor de sortie (P3).

10. Un circuit générateur (3) pour rampes de tension selon la revendication 9, **caractérisé en ce que** ledit premier transistor PMOS (P6) est inséré entre ladite première sortie (X2) et ledit noeud interne de circuit (X6) et est pourvu d'une borne de commande reliée à une borne de commande dudit second transistor PMOS (P7) qui est conformé en diode et à son tour inséré entre ledit noeud interne de circuit (X6) et ledit noeud interne (X4) dudit étage différentiel (4).

11. Un circuit générateur (3) pour rampes de tension selon la revendication 8, **caractérisé en ce qu'**il comprend en outre un transistor (P5) qui est inséré entre ladite première sortie (X2) et ladite borne de commande dudit premier transistor de sortie (P3) et possédant une borne de commande reliée à ladite seconde sorite (X1) dudit étage différentiel (4).

12. Un procédé pour générer un signal de tension à double rampe pour une charge capacitive, ledit signal de tension à double rampe présentant une première partie dont la pente est supérieure à une seconde partie, **caractérisé en ce que** la génération de ladite tension à double rampe comprend une première phase effectuée au moyen d'un étage suiveur de tension NMOS relié à ladite charge capacitive, et une seconde phase effectuée au moyen d'un étage de sortie PMOS, lesdites phases étant alternativement activées en fonction du niveau de tension requis par la charge, en utilisant un circuit générateur tel que défini dans une quelconque revendication précédente.

13. Un procédé selon la revendication 12, **caractérisé en ce que** lesdites première et seconde phases sont effectuées au moyen d'un étage de sortie PMOS avec un valeur réduite du produit entre transconductance (gm) et gain en boucle (A).

14. Un procédé selon la revendication 12, **caractérisé en ce que** lesdites première et seconde phases sont effectuées au moyen :

- dudit premier transistor de sortie (P) qui est piloté par une seconde sorite (X1) dudit étage différentiel (4) ; et
- ladite boucle de régulation (5) pour activer le premier ou le second transistors de sortie (P3, N3) en fonction du niveau de tension requis par ladite charge.

FIG. 1
PRIOR ART

FIG. 2
PRIOR ART

FIG. 3

FIG. 4A

FIG. 4B

FIG. 5

FIG. 6

FIG. 7

FIG. 8

FIG. 9